Europäisches Patentamt

European Patent Office

Office européen des brevets

(11) Publication number: **0 519 177 A2**

# EUROPEAN PATENT APPLICATION

(21) Application number: **92106633.8**

(22) Date of filing: **16.04.92**

(51) Int. Cl.5: **C09J 7/00**, //(C09J163/04, 175:12)

(30) Priority: **21.06.91 JP 177667/91**

(43) Date of publication of application:
**23.12.92 Bulletin 92/52**

(84) Designated Contracting States:
**DE FR GB**

(71) Applicant: **CHISSO CORPORATION**
**6-32, Nakanoshima 3-chome Kitaku**
**Osaka(JP)**

(72) Inventor: **Itami, Setsuo**
**17, Tatsumidaihigashi 2-chome**
**Ichiharashi, Chiba-ken(JP)**
Inventor: **Yano, Hitoshi**
**17, Tatsumidaihigashi 2-chome**
**Ichiharashi, Chiba-ken(JP)**
Inventor: **Kikuta, Kazutsune**
**8890, Goi**
**Ichiharashi, Chiba-ken(JP)**

(74) Representative: **Kraus, Walter, Dr. et al**
**Patentanwälte Kraus, Weisert & Partner**
**Thomas-Wimmer-Ring 15**
**W-8000 München 22(DE)**

(54) **A thermosetting adhesive film and a process for applying the same.**

(57) A thermosetting adhesive film having well retaining any of storage-stability, adhesion strength, heat resistance, chemical resistance and electrical characteristics is provided,

which film is obtained by molding a composition consisting of 100 parts by weight of a copolymer consisting of polycaprolactone polyol, a diamine and a diisocyanate, 30 to 300 parts by weight of an epoxy-novolak resin, 3 to 100 parts by weight of a flexibilizer and 0.2 to 20 parts by weight of a film-forming agent.

EP 0 519 177 A2

BACKGROUND OF THE INVENTION

1. Field of the Invention

This invention relates to a thermosetting adhesive film comprising as its main components, a copolymer consisting of polycaprolactone polyol, a diamine and a diisocyanate and an epoxy-novolak type resin, and a process for applying the film.

2. Description of the Related Art

In general, thermosetting adhesive films have been broadly used in the electronics-related fields, and their use applications are directed, for example, to preparation of a multi-ply of flexible printed wiring sheets, adhesion of a conductor circuit onto a base for printed wiring sheets, fixing of surface-mounting parts, adhesion of semiconductor chips, assembly of electronic parts, etc.

For multifying flexible printed wiring sheets, thermosetting adhesive films are used and the multification is carried out by heat press or roll press. At that time, it is required to be free from resin flow, and further, in the case of ultimately thermoset adhesive films, superior adhesion strength, heat resistance, chemical resistance, electrical characteristics, etc. are required. Furthermore, at the step of applying through-hole processing, it is required to be free from resin smears.

For these requirements, many thermosetting adhesive films and products obtained by applying these films have been commercially availed, but rubbery, epoxy, acrylic, polyamide materials, etc. as main materials cannot be regarded as retaining all of required properties such as storage-stability, adhesion strength, heat resistance, chemical resistance, electrical characteristics, etc. Further, polyimide materials whose development has recently been advanced have very high softening points or no softening point; hence processing conditions at very high temperatures are required so that there is raised a drawback of inferior processability.

Heretofore, as adhesives, a number of materials have been proposed such as those of nitrile rubbers (Japanese patent application laid-open Nos. Sho 51-135936 and Sho 57-3877), polyamides (Japanese patent application laid-open No.Sho 54-125285), polyesters ( Japanese patent application laid-open Nos. Sho 50-16866 and Sho 54-7441), polyimides (Japanese patent application laid-open Nos. Sho 62-30122 and Sho 62-232475), polyacrylic materials, etc. However, none of these materials retain any of the required properties such as storage-stability, adhesion strength, heat resistance, chemical resistance, electrical characteristics, processability, etc.

The object of the present invention is to provide a thermosetting adhesive film having superior storage-stability, adhesion strength, heat resistance, chemical resistance, electrical characteristics, processability, etc., and a process for applying the films.

The present inventors have made extensive research in order to find a thermosetting adhesive film satisfying any of the required properties and a process for applying the film. As a result, we have found that a composition mentioned below is superior in the storage-stability, heat resistance, adhesion strength, chemical resistance and electrical characteristics when the composition is used as a thermosetting adhesive film.

As apparent from the foregoing, the object of the present invention is to provide a thermosetting adhesive film satisfying any of the above required properties and a composition for producing the film.

The thermosetting adhesive film of the present invention can be thermoset at relatively low temperatures; hence it is far superior in the processability so that it is suitably usable as an adhesive for producing various composite materials for example when a multiply of a flexible printed wiring sheet is prepared; when a reinforcing sheet is adhered; when copper foil or copper wire is made composite with a polyimide film; or the like cases.

SUMMARY OF THE INVENTION

The present invention has the following constitutions (1) to (4):
(1) A thermosetting adhesive film molded from a composition obtained by blending 30 to 300 parts by weight of an epoxy-novolak resin, 3 to 100 parts by weight of a flexibilizer and 0.2 to 20 parts by weight of a film-forming agent with 100 parts by weight of a copolymer consisting of polycaprolactone polyol, a diamine and a diisocyanate.
(2) A thermosetting adhesive film according to item (1), wherein said copolymer is obtained by polymerizing 20 to 80 % by weight of said polycaprolactone polyol, 10 to 40% by weight of said diamine

2

and 10 to 40% by weight of said diisocyanate based upon the total weight of said polycaprolactone polyol, said diamine and said diisocyanate.

(3) A thermosetting adhesive film according to item (1), obtained by coating said composition onto a release film and drying the resulting material at 130° to 150°C, into a semi-cured state.

(4) A process for applying a thermosetting adhesive film as set forth in item (1), wherein said thermosetting adhesive film and a material to be adhered are subjected to an ultimate cure at a low temperature of 150° to 200°C.

DETAILED DESCRIPTION OF PREFERRED EMBODIMENTS

The constitutions and effectiveness of the present invention will be described in more detail, but it should not be construed to be limited thereto.

The first invention of the present invention consists in a thermosetting adhesive film mold from a composition obtained by blending about 30 to 300 parts by weight, preferably about 50 to 150 parts by weight of an epoxy-novolak resin, about 3 to 100 parts by weight, preferably about 5 to 50 parts by weight of a flexibilizer and about 0.2 to 20 parts by weight, preferably about 0.4 to 15 parts by weight of a film-forming agent, with 100 parts by weight of a copolymer consisting of polycaprolactone polyol, a diamine and a diisocyanate.

The above-mentioned thermosetting adhesive film may also contain a curing catalyst for the epoxy resin, etc. The thermosetting adhesive film can satisfy any of the above-mentioned required properties, and is superior in the processability and further, is at the same time, provided with sufficient properties suitable to a specification of adhesive films for producing laminated sheets, etc.

Polycaprolactone polyol (hereinafter abbreviated to "PC") as one of the materials used in the copolymer consisting of polycaprolactone polyol, a diamine and a diisocyanate has no particular limitation to the molecular weight and the number of terminal hydroxyl group, and commercially available products may be used as they are. Placcel® made by Daicel Co., Ltd., NIAX PCP® made by UCC Co., Ltd., etc. may be exemplified.

Further, as the diamine, carbocyclic aromatic diamines, heterocyclic diamines, aliphatic diamines, alicyclic diamines, araliphatic diamines, etc. are exemplified.

As examples of carbocyclic aromatic diamines, the following compounds are mentioned:
1,4-phenylenediamine, 1,3-phenylenediamine,
4,4'-diaminodiphenyl ether, 4,4'-diaminodiphenylmethane, 4,4'-diaminodiphenyl sulfone, etc.
As examples of heterocyclic diamines, the following compounds are mentioned:
2,6-diaminopyridine, 2,4-diaminopyrimidine,
2,4-diamino-s-triazine, etc.
As examples of aliphatic diamines, the following compounds are mentioned:
dimethylenediamine, hexamethylenediamine, 2,2-dimethylpropylenediamine, etc.
As examples of alicyclic diamines, the following compounds are mentioned:
1,4-diaminocyclohexane, 4,4'-diaminodicyclohexylmethane, etc.
As examples of araliphatic diamines, the following compounds are mentioned:
1,3-bis(aminomethylbenzene), 1,4-bis(aminomethylbenzene), etc.
These amines may be used alone or in admixture.
As examples of diisocyanate, the following compounds are mentioned:
2,4-tolylene diisocyanate, 2,6-tolylene diisocyanate, diphenylmethane diisocyanate, hexamethylene diisocyanate, isophorone diisocyanate, cyclohexane diisocyanate, etc.

As the process for producing the above-mentioned copolymer, known processes such as solution polymerization, emulsion polymerization, etc. may be employed.

The proportions of PC, a diamine and a diisocyanate used in the production of the above copolymer are preferred to be about 20 to 80% by weight of PC, about 10 to 40% by weight of a diamine and about 10 to 40% by weight of a diisocyanate, based upon the total weight of these compounds.

As the epoxy-novolak resin used in the present invention, epoxy-cresol novolak resin, epoxy-phenol novolak resin, resins retarded by halogenating the foregoing resins, etc. are exemplified. More concretely, DEN-438 (tradename) and QUATREX 2010 (tradename), each made by Dow Chemical Co., Ltd., EOCN-1025 (tradename) and BREN-S (tradename), each made by Nihon Kayaku Co., Ltd., YDPN-638 (tradename) and YDCN-702 (tradename), each made by Tohto Kasei Co., Ltd., etc. are exemplified.

If the quantity thereof added is more than about 300 parts by weight in excess of the above-mentioned composition ratio, there is a fear of damaging the flexibility of the resins, while if the quantity is less than about 30 parts by weight, there is a fear of damaging the heat resistance, chemical resistance, etc.

As the flexibilizer used in the present invention, the following compounds are exemplified:

1. Epoxy group

① Monoepoxide

Phenylglycidyl ether, dibromophenyl ether, aliphatic glycidyl ethers, alicyclic monoepoxides, etc.

② Diepoxide

Polypropyleneglycol diglycidyl ether, polypropyleneglycol diglycidyl ether containing bisphenol nucleus, partial adduct of epoxy bisphenol A resin, polysulfide terminal-modified epoxy resin, N,N-diglycidylated aniline derivative, dicarboxylic acid diglycidyl ester, alicyclic epoxy resin, etc. 2. Non-epoxy group

Terminal amino group-modified butadiene-acrylnitrile copolymer, terminal carboxyl group-modified butadiene-acrylonitrile copolymer, etc.

If the quantity of the flexibilizer added is more than 100 parts by weight in excess of the above composition proportion, the heat resistance and chemical resistance are inferior, while if it is less than 3 parts by weight, this has a bad effect upon electrical characteristics.

As the film-forming agent used in the present invention, finely-divided powder products of silica and alumina are preferred. More concretely, as finely-divided silica, surface-non-treated standard products such as Aerosil 200 and Aerosil 300 (each tradename), made by Japan Aerosil Co., Ltd., etc., and surface-treated, hydrophobic products such as Aerosil R972 and Aerosil RY200 (each, tradename), made by the same compnay, etc. are exemplified. Further, as finely divided powder alumina, aluminum oxide C (tradename) made by Japan Aerosil Co., Ltd., etc. are exemplified.

If the quantity of the film-forming agent added is more than 20 parts by weight, in excess of the above composition proportion, the surface after coated, of the resulting thermosetting adhesive composition becomes notably rough, while if it is less than 0.2 part by weight, no film can be formed.

An organic solvent may be added into the thermosetting adhesive composition of the present invention in the aspect of the film-forming properties at the time of coating. Examples of such solvent are ketone solvents such as methyl ethyl ketone, acetone, etc., ester solvents such as $\gamma$-butyrolactone, butyl acetate, ethyl acetoacetate, etc., alcohol solvents such as butanol, benzyl alcohol, etc., Cellosolve® group solvents, carbitol group solvents and ester or ether derivatives of the foregoing, amide solvents such as N,N-dimethylformamide, N-methyl-2-pyrrolidone, etc., dimethylsulfoxide, phenolic solvents such as phenol, cresol, etc., nitro compound group solvents, chlorinated hydrocarbon group solvents such as chloroform, methylene chloride, etc., aromatic group solvents such as toluene, xylene, etc., aliphatic group solvents such as heptane, cyclohexane, etc. These may be used alone or in admixture.

As the curing catalyst for the thermosetting adhesive film of the present invention, curing catalysts of epoxy resins may be used. Since such curing catalysts are necessary to have storage-stability, they are preferred to be a latently curing catalyst which has a low activity at room temperature and has a high activity at the time of heat curing. Concretely, boron trifluoride-amine complex, dicyandiamide, etc. are preferred. The quantity of such curing catalysts added is 0.1% by weight or more, preferably 0.3% by weight or more, more preferably 1% by weight or more, and 80% by weight or less, preferably 50% by weight or less, more preferably 10% by weight or less, based upon the weight of the above epoxy resins.

The thermosetting adhesive composition of the present invention is a product obtained by making up into ink, a copolymer of the above PC, diamine and diisocyanate, an epoxy-novolak resin, a flexible epoxy resin, a film-making agent, an organic solvent, a curing catalyst, etc., in a conventional manner, using a three-roll ink mill, and having a superior storage-stability.

As to the process for applying the thermosetting adhesive film, of the present invention, the thermosetting adhesive composition is firstly coated onto a release film such as OPP (biaxially oriented polypropylene film), PP (polypropylene film), release paper, etc. by means of a bar coater or the like, followed by drying the resulting material at 130° to 150°C for 10 to 90 minutes, preferably at 135° to 145°C for 30 to 60 minutes, in a hot-air drying oven. This drying affords a film in a semi-cured state. This semi-cured state refers to a state which is half-cured and soft . The resulting thermosetting adhesive film is then peeled off from the release film, followed by placing the former film between materials to be adhered such as flexible printed wiring sheets, etc. and subjecting the resulting material to thermal contact bonding at 150° to 200°C for 5 to 60 minutes under a pressure of 10 to 50 Kg/cm$^2$, preferably at 160° to 180°C for 15 to 30 minutes under a pressure of 10 to 30 Kg/cm$^2$, by means of a heat-pressing machine or the like to cure the material and thereby obtain a laminated body.

Next, the present invention will be concretely described by way of Reference example of preparation of the copolymer consisting of PC, a diamine and a diisocyanate used in the present invention, Examples of the present invention and Comparative examples, but the present invention should not be construed to be limited to these Examples. In addition, "part" in Reference example, Examples and Comparative examples refers to part by weight unless otherwise indicated.

Reference example

A reaction vessel provided with a stirrer, a condenser, a dropping means, a nitrogen gas-blowing-in tube and a thermometer was employed.

The reaction vessel was firstly heated up to 50°C, followed by purging with nitrogen gas, adding 10 parts of diphenylmethane diisocyanate and 25 parts of a polycaprolactone diol having an average molecular weight of 1,250, reacting the contents with stirring at 80°C for 4 hours in nitrogen atmosphere, and cooling the resulting material down to 50°C after completion of the reaction.

On the other hand, a solution of 9.95 parts of 4,4'-diaminodiphenyl sulfone in 40 parts of dimethylformamide was prepared, followed by adding the solution to the above reaction product with stirring at 50°C for 2 hours in nitrogen atmosphere, and cooling the reaction material down to room temperature. The reaction product had a resin concentration of 53% by weight.

Example 1

47.7 Parts of an epoxy-novolak resin (DEN-438, tradename of product made by Dow Chemical Co., Ltd.), 8 parts of an epoxy-bisphenol resin (EPIKOTE 4000, tradename of product made by Asahi Denka Kogyo Co., Ltd.), 1.8 part of a film-forming agent (Aerosil 300, tradename of product made by Nihon Aerosil Co., Ltd.), and 0.9 part of boron trifluoride ethylamine ($BF_3EtNH_2$) were mixed with 100 parts of the copolymer obtained in Reference example, followed by three times kneading the mixture by means of a three-roll mill to obtain a pasty thermosetting adhesive composition.

The thus obtained thermosetting adhesive composition was applied onto a release film (OPP; 50 $\mu$m) by means of a bar coater so as to give a thickness of 50 $\mu$m after dried, followed by drying the resulting material in a hot-air drying oven at 140°C for 45 minutes, to obtain a thermosetting adhesive film in a semi-cured state. Further, this film was placed between the respective shining surfaces of copper foils, followed by pressing and thermosetting the resulting material at 160°C, under 20 Kg/cm$^2$, for 30 minutes to obtain a laminated product. Thereafter, the heat resistance, adhesion strength, chemical resistance and electrical characteristics of the thermoset product were observed.

Heat resistance:

The thermoset product was floated on a solder bath at 280°C for 60 seconds. The peeling between the copper foil and the adhesive, blister and discoloration of the adhesive at that time were judged by naked eyes. When no change in the above items of the product was observed before and after the test, the product was regarded as good. When change in some of the above items of the product was observed, the product was regarded as inferior.

Adhesion strength:

It was measured according to JIS C6481, using a sample of 1 cm wide and in the direction of 180°.

Electrical characteristics:

The characteristics were observed according to JIS C6481, that is, a material formed by etching a parallel pattern having a distance between lines of 1.0 mm and a total extended length of 80 mm had DC 100V impressed thereonto, and the insulation resistance between lines after elapse of one minute was regarded as representing the electrical characteristics.

Chemical resistance:

When a sample was immersed in methylene chloride, methyl ethyl ketone, 10% HCℓ aqueous solution or 10% NaOH aqueous solution at room temperature for 24 hours, peel or blister of the coating, foaming, solving, etc. were observed by naked eyes, and when no abnormality was observed with regard to any of the above chemicals, the sample was regarded as good.

The physical properties of the thermoset product was shown in the following Table:

| | Heat resistance on solder (280°C, 60 sec., float) | Peel strength (kgf/cm) | Chemical resistance | Insulation resistance between lines (Ω) | Film properties | Resin flow |
|---|---|---|---|---|---|---|
| Example 1 | Good | 1.7 | No abnormality | $1.5 \times 10^{12}$ | No problem | No problem |
| " 2 | Good | 2.0 | No abnormality | $1.0 \times 10^{12}$ | No problem | No problem |
| " 3 | Good | 1.7 | No abnormality | $1.5 \times 10^{12}$ | No problem | No problem |
| " 4 | Good | 1.5 | No abnormality | $2.0 \times 10^{12}$ | No problem | No problem |
| " 5 | Good | 1.5 | No abnormality | $1.5 \times 10^{12}$ | No problem | No problem |
| Comp. ex. 1 | Good | 1.6 | No abnormality | $2.0 \times 10^{12}$ | Film, shrunk | No problem |
| " 2 | - | - | - | - | Inferior | - |
| " 3 | Good | 0.9 | No abnormality | $2.5 \times 10^{12}$ | No problem | No problem |
| " 4 | Good | 2.0 | No abnormality | $1.5 \times 10^{12}$ | No problem | Squeezed out |

6

Example 2

A laminated body was obtained in the same manner as in Example 1 except that a polycaprolactone diol having an average molecular weight of 2,000 was used in place of the polycaprolactone diol having an average molecular weight of 1,250 in Reference example.

Example 3

A laminated product was obtained in the same manner as in Example 1 except that ethyl acetoacetate was used in place of dimethylformamide as solvent in Reference example.

Example 4

A laminated body was obtained in the same manner as in Example 1 except that pressing at 180°C, under 20 Kg/cm$^2$ and for 15 minutes was carried out in place of the pressing at 160°C, under 20 Kg/cm$^2$ and for 30 minutes in Example 1.

Example 5

A laminated body was obtained in the same manner as in Example 1 except that drying in a hot-air drying oven at 150°C for 20 minutes to obtain a thermosetting adhesive film in a semi-cured state was carried out in place of drying in a hot-air drying oven at 140°C for 45 minutes to obtain a thermosetting adhesive film in a semi-cured state in Example 1.

Comparative example 1

A laminated body was obtained in the same manner as in Example 1 except that 47.7 parts of an epoxy-novolak resin (DEN-438, tradename of product made by Dow Chemical Co., Ltd.) and 0.9 part of boron trifluoride ethylamine ($BF_3$ $EtNH_2$) were mixed with 100 parts of the copolymer obtained in Reference example.

Comparative example 2

A thermosetting adhesive composition was obtained in the same manner as in Example 1 except that the film-forming agent (Aerosil 300, tradename of product made by Nihon Aerosil Co., Ltd.) was excluded in Example 1. However, when the composition was coated onto a release film (OPP; 50 $\mu$m), cissing was observed on the release film; thus, it was impossible to well coat the composition.

Comparative example 3

A laminated product was obtained in the same manner as in Example 1 except that pressing at 220°C under 20 Kg/cm$^2$ and for 10 minutes was carried out in place of the pressing at 160°C under 20 Kg/cm$^2$ and for 30 minutes in Example 1.

Comparative example 4

A laminated body was obtained in the same manner as in Example 1 except that drying in a hot-air drying oven at 125°C for 120 minutes to obtain a thermosetting adhesive film in a semi-cured state was carried out in place of the drying in a hot-air drying oven at 140°C for 45 minutes to obtain a thermosetting adhesive film in a semi-cured state.

Effectiveness of the Invention

As apparent from the foregoing, the thermosetting adhesive film of the present invention obtained from a definite thermosetting adhesive composition has superior storage-stability, heat resistance, chemical resistance and electrical characteristics, and when the composition is coated onto a release film of OPP or the like and dried, it is possible to easily form a thermosetting adhesive film in a semi-cured state.

Further, since the thermosetting adhesive film of the present invention can be thermoset at relatively

EP 0 519 177 A2

low temperatures, it is far superior in the processability and suitably usable as an adhesive for producing various composite materials (for example, preparation of multi-ply of flexible printed wiring sheet, adhesion of reinforced sheet, composite materials of copper foil or copper wire with a polyimide film, etc.).

## Claims

1. A thermosetting adhesive film molded from a composition obtained by blending 30 to 300 parts by weight of an epoxy-novolak resin, 3 to 100 parts by weight of a flexibilizer and 0.2 to 20 parts by weight of a film-forming agent with 100 parts by weight of a copolymer consisting of polycaprolactone polyol, a diamine and a diisocyanate.

2. A thermosetting adhesive film according to claim 1 , wherein said copolymer is obtained by polymerizing 20 to 80 % by weight of said polycaprolactone polyol, 10 to 40% by weight of said diamine and 10 to 40% by weight of said diisocyanate based upon the total weight of said polycaprolactone polyol, said diamine and said diisocyanate.

3. A thermosetting adhesive film according to claim 1 , obtained by coating said composition onto a release film and drying the resulting material at 130° to 150°C, into a semi-cured state.

4. A process for applying a thermosetting adhesive film as set forth in claim 1 , wherein said thermosetting adhesive film and a material to be adhered are subjected to an ultimate cure at a low temperature of 150° to 200°C.

8